Europäisches Patentamt

European Patent Office

Office européen des brevets

(19)

(11) **EP 0 942 302 A2**

(12) **EUROPÄISCHE PATENTANMELDUNG**

(43) Veröffentlichungstag:
    **15.09.1999 Patentblatt 1999/37**

(51) Int. Cl.$^6$: **G02B 6/42**

(21) Anmeldenummer: **98117620.9**

(22) Anmeldetag: **17.09.1998**

(84) Benannte Vertragsstaaten:
    **AT BE CH CY DE DK ES FI FR GB GR IE IT LI LU MC NL PT SE**
    Benannte Erstreckungsstaaten:
    **AL LT LV MK RO SI**

(30) Priorität: **12.03.1998 DE 19810624**

(71) Anmelder: **ROBERT BOSCH GMBH**
    **70049 Stuttgart (DE)**

(72) Erfinder:
    • **Hauer, Heiner**
      **70734 Fellbach (DE)**
    • **Kuke, Albrecht**
      **71549 Auenwald (DE)**
    • **Moess, Eberhard**
      **71540 Murrhardt (DE)**
    • **Schwaderer, Bernhard**
      **71554 Weissach (DE)**

(54) **Elektrooptisches Modul**

(57) Elektrooptisches Modul mit

- transparentem Substrat (1),
- Sendelaser (512) in einem ersten Vorraum, der einer Breitseite (11) vorgelagert ist,
- einer Linse (15) zur Strahlformung für die Einkopplung in eine Einkopplungsfläche (42) im Vorraum der anderen Breitseite (14).

- Die Breitseite (11) hat eine kristallographische (100)-Orientierung,
- im ersten Vorraum ist eine die Sendestrahlung reflektierende und auf die erste Breitseite (11) werfende Fläche (21) angeordnet,
- diese hat eine kristallographische (111)-Orientierung,
- im Vorraum der zweiten Breitseite (14) ist der Einkopplungsfläche (42) eine Aufnahmevorrichtung (300, 310) für einen Halter (400) eines optischen Wellenleiters (4) zugeordnet,
- die Linse (15) ist lateral so lokalisiert, daß die Richtung des Mittenstrahls (123,124) der Sendestrahlung im Vorraum der zweiten Breitseite (14) weniger von dem Lot auf der zweiten Breitseite (14) abweicht als innerhalb des Substrats (1).

Anwendung bei der Leadframe-Technik.

Fig. 3

EP 0 942 302 A2

**Beschreibung**

Stand der Technik

Die Erfindung geht von der Gattung aus, wie im unabhängigen Anspruch 1 angegeben.

Ein solches Modul ist aus der deutschen Patentschrift DE 195 27 026 C2 bekannt.

Die Erfindung befaßt sich mit einem Modul, insbesondere mit einem optischen Transceiver, der zum Einbau in ein Receptacle für Leadframe-Montagetechnik geeignet ist. In der deutschen Patentanmeldung 197 55 806.2 wurde ein Receptacle für Leadframe-Montagetechnik vorgeschlagen.

Für die Montage in einem Receptical wird üblicherweise als Sendebauelement eine kantenemittierende Halbleiterlaserdiode mit integrierter Strahltransformation bevorzugt. Solche Halbleiterlaserdioden haben in Lichtausbreitungsrichtung nach dem aktiven Laserkanal auf dem gleichen Chip einen passiven Transformationswellenleiter, der den Modenfelddurchmesser des Lasers von ca. 1 $\mu$m auf ca. 4,5 $\mu$m vergrößert und somit eine bessere Anpassung an den Modenfelddurchmesser einer Einmodenfaser von 10 $\mu$m ermöglicht. Gleichzeitig wird bei dieser Strahltransformation der Abstrahlwinkel von ca. 30° auf etwa 12° reduziert. Solche nach dem Stand der Technik bekannten Laserdioden mit Strahltransformation (engl.: SSC-Laser = Spot Size Converted Laserdiode) werden üblicherweise für die Direktankopplung einer Einmodenfaser verwendet. Der Laser strahlt dabei in eine an seiner Stirnseite in geringem Abstand angeordnete Faser ein (Stirnflächenkopplung). Die Faserachse muß dazu in der Montageebene (Emissionsrichtung) des Lasers verlaufen. Dabei kann der Laser durch Rückreflexionen an der Faserstirnfläche in seiner Abstrahlcharakteristik gestört werden.

Bei der Verwendung des Lasers in einem Receptacle mit Leadframe-Montagetechnik verläuft die Achse der Steckbuchse und damit der optischen Faser senkrecht zur Emissionsrichtung (Montageebene) des Lasers, daher ist hier die oben beschriebene Stirnflächenkopplung nicht möglich. Bei einem Transceiver, der zusätzlich zu einem Sendeelement (z. B. Sendelaser) noch ein Empfangselement (z. B. Fotodiode) aufweist, läßt sich außerdem bei einer Direktankopplung der Faser an den Laser wegen des erforderlichen geringen Abstandes zwischen den Stirnflächen von Laser und Faser kein strahlteilendes Element zur Trennung der Sende- von der Empfangsstrahlung unterbringen.

Vorteile der Erfindung

Der Anmeldungsgegenstand mit den Merkmalen des Anspruches 1 hat folgenden Vorteil:
Das Modul ist für den Einbau in ein Receptacle geeignet und im Großnutzen kostengünstig herstellbar. Es kann als Sendemodul oder Transceiver ausgebildet sein.

Vorteilhafte Weiterbildungen sind in den abhängigen Ansprüchen angegeben, deren Merkmale auch, soweit sinnvoll, miteinander kombiniert werden können.

Während bei dem Modul für Leadframe-Montagetechnik nach der deutschen Patentanmeldung 197 55 806.2 für die Sende- und für die Empfangsrichtung zwei getrennte optische Wellenleiter und somit zwei Steckbuchsen und je ein getrenntes Sende- und Empfangsteil vorgesehen sind, ist ein Transceiver-Modul nach einer Weiterbildung der vorliegenden Erfindung für nur einen optischen Wellenleiter für die Sende- und Empfangsrichtung vorgesehen. Dabei werden für die Sende- und die Empfangssignale zwei unterschiedliche Wellenlängen verwendet. Zur Richtungstrennung zwischen Sende- und Empfangspfad dient ein wellenlängenselektives Filter.

Zeichnung

Ausführungsbeispiele der Erfindung sind in der Zeichnung dargestellt und im Folgenden näher erläutert. Dabei sind bei mehreren Figuren jeweils dieselben Bezugszeichen für im wesentlichen gleiche Teile verwendet. Schematisch ist jeweils im Schnitt gezeigt in

Figur 1:     ein Transceiver-Modul nach der Erfindung, mit Strahlengang,
Figur 2:     ein Transceiver-Modul, das auf einer Seite eines Leadframe montiert ist,
Figur 3:     ein Transceiver-Modul mit integriertem Transceiver-Chip als Sendeelement.

Beschreibung des Ausführungsbeispiels

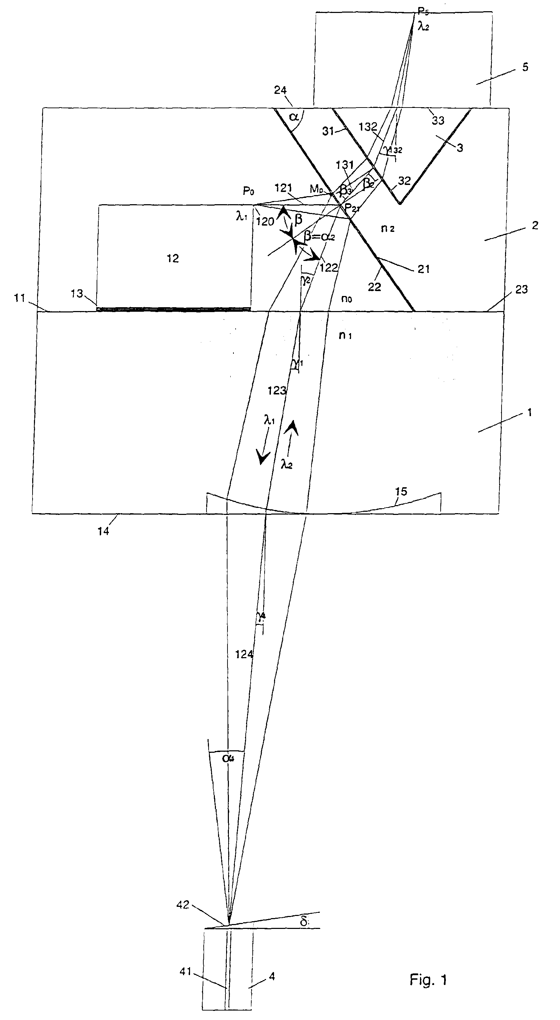

Fig. 1 zeigt den Aufbau und den Strahlengang für ein Ausführungsbeispiel eines erfindungsgemäßen Transceiver-Moduls. Ein erstes Siliziumsubstrat 1 mit planparallelen Breitseiten 11, 14 trägt auf einer ersten Breitseite 11 als Sendebauelement 12 einen Sendelaser, der mit Hilfe einer Montageschicht 13 befestigt ist. Das aus der Lichtaustrittsfläche 120 auf der Stirnfläche des Sendelasers 12 austretende Strahlenbündel mit dem Mittenstrahl 121 bei der Sendewellenlänge $\lambda$1 trifft auf eine geneigte Fläche 21. Bevorzugt wird diese Fläche durch einen anisotropen Ätzprozeß in einem zweiten Siliziumsubstrat 2 erzeugt. Die Strukturierung des zweiten Siliziumsubstrats 2 kann hierbei vorteilhafterweise durch Strukturierung eines Siliziumwafers im Vielfachnutzen geschehen. In der Fig. 1 ist nur ein Nutzen dargestellt. Die Fläche 21 ist mit einer dichroitischen Filterschicht 22 beschichtet, welche die Sendewellenlänge $\lambda 1$ reflektiert und die Empfangswellenlänge $\lambda 2$ durchläßt. Durch den anisotropen Silizium-Ätzprozeß bedingt, weist die Fläche 21 eine kristallographische (111)-Orientierung auf und ist gegenüber der (100)-orientierten Montagefläche 23 des Siliziumsubstrates 2 unter einem Böschungswinkel von

$$\alpha = \arctan(\sqrt{2}) = 54{,}7°$$

geneigt. Der Einfallswinkel des Mittenstrahls 121 im Strahlenbündel gegenüber der Flächennormalen der Fläche 21 ist

$$\beta = 90° - \alpha = 35{,}3°.$$

Der Mittenstrahl 122 des reflektierten Strahlenbündels hat gegenüber der Flächennormalen der ersten Breitseite 11 des ersten Siliziumsubstrates 1 einen Richtungswinkel von

$$\gamma_2 = 90° - 2 \cdot \beta = 19{,}5°.$$

Beim Eintritt in das Siliziumsubstrat 1 wird das Strahlenbündel zum Lot hingebrochen. Der Richtungswinkel $\gamma 1$ des Strahlenbündels im Siliziumsubstrat 1 ist

$$\gamma_1 = \arcsin((n_0/n_1) \cdot \sin(\gamma_2)).$$

Dabei ist $n_0$ der Brechungsindex im Raum zwischen der ersten Breitseite 11 des Substrats 1, der Filterschicht 22 und der Lichtaustrittsfläche 120 ist. Dieser Raum kann in einem ersten Ausführungsbeispiel der Erfindung (Fall 1) mit Luft oder in einem zweiten Ausführungsbeispiel (Fall 2) mit einem transparenten Kleber ausgefüllt sein. Für Luft ist $n_0 = n_{0L} = 1$. Für das zweite Ausführungsbeispiel wird in der nachfolgenden beispielhaften Berechnung für den transparenten Kleber ein Brechungsindex von $n_{0k} = 1{,}5$ angenommen. Zur Vermeidung von fresnelschen Reflexionsverlusten wird die erste Breitseite 11 zumindest im Bereich des Strahleintritts mit einer Antireflexionsschicht belegt. Silizium hat bei einer Lichtwellenlänge von $\lambda = 1{,}55 \; \mu m$, die in der Berechnung beispielhaft zugrunde gelegt wird, einen Brechungsindex von 3,4777. Mit diesen Werten erhält man für Luft im Raum oberhalb der Fläche 11

$$\gamma_{1L} = 5{,}50° \quad \text{Fall 1}$$

und für Kleber im Raum oberhalb der ersten Breitseite 11

$$\gamma_{1K} = 8{,}27° \quad \text{Fall 2}$$

Auf der zweiten Breitseite 14 des Substrates 1 ist als strukturierter Oberflächenbereich zur Fokussierung des Sendestrahlenbündels eine Linse 15 vorgesehen. Vorteilhafterweise ist diese Linse, wie nach dem Stand der Technik bekannt, als integrierte Linse direkt auf dem Siliziumsubstrat 1 im Vielfachnutzen strukturiert. Die Oberfläche der Linse ist mit einer Antireflexionsschicht belegt. Diese Linse hat die Aufgabe, das aus dem Laser austretende divergierende Strahlenbündel in ein konvergierendes Strahlenbündel umzuwandeln und dabei die Lichtaustrittsfläche 120 auf eine Einkopplungsfläche innerhalb der Stirnfläche 42 eines optischen Lichtwellenleiters 4 (nämlich im Kern 41) abzubilden. Zur Vermeidung von Rückreflexionen in den Laser muß zwischen der Normalen der Stirnfläche 42 und der Richtung des Mittenstrahls 124 des konvergierenden Strahlenbündels ein Winkel $\alpha_4$ eingeschlossen sein, der größer ist als der Konvergenzwinkel zwischen dem Mittenstrahl und einem Randstrahl des konvergierenden Strahlenbündels. Nach dem Stand der Technik sind hierfür optische Stecker für Einmoden-Lichtleitfasern erhältlich, deren Stirnflächennormale gegenüber der Faserachse einen Winkel von typischerweise $\delta = 8°$ einschließt. Ein aus der Faser austretendes Lichtbündel wird dabei unter dem Winkel von

$$\alpha_4 = \arcsin(n_f \cdot \sin \delta) = 11{,}7°$$

zur Flächennormalen gebrochen, wobei $n_f = 1{,}46°$ der Brechungsindex des Faserkerns ist. Der Winkel zwischen der Faserachse und dem Mittenstrahl eines austretenden Strahlenbündels ist dann

$$\varepsilon = \alpha_4 - \delta = 3{,}7°$$

Um diesen Winkel muß auch ein einfallendes Strahlenbündel gegenüber der Faserachse geneigt eingekoppelt werden, um Einkoppelverlußte infolge Winkeldejustierung zu vermeiden. Um eine kostengünstige Montage einer Steckbuchse in einem Receptacle zu ermöglichen, muß die Achse der Steckbuchse und damit auch eines eingesteckten Steckers senkrecht zur Montagefläche des Receptacles geführt sein. Daraus folgt, daß der Mittenstrahl 124 des konvergierenden Bündels einen Winkel von $\varepsilon = 3,7°$ mit der Flächennormalen der zweiten Breitseite 14 des Siliziumsubstrates 1 einschließen muß. Würde das Strahlenbündel ohne die Linse 15 aus der ebenen Breitseite 14 austreten, so würde der Mittenstrahl vom Lot auf der Breitseite 14 weggebrochen. Im ersten Fall wäre dieser Winkel 19,5° und im zweiten Fall 30°. Diese Winkel wären gegenüber dem erforderlichen Winkel von $\varepsilon = 3,7°$ viel zu groß. Setzt man jedoch die konvexe Linse 15 so, daß die Strahlrichtung des Mittenstrahls durch den Krümmungsmittelpunkt $M_P$ der Linse verläuft, so durchdringt der Mittenstrahl die Linse ungebrochen und tritt im Fall 1 unter dem Winkel von 5,50° und im Fall 2 unter dem Winkel von 8,27° in die Faser ein. Dies ist immer noch eine beträchtliche Abweichung von dem Idealwinkel $\varepsilon = 3,7°$. Erfindungsgemäß läßt sich der Winkel $\varepsilon = 3,7°$ dadurch erreichen, indem die Linse lateral versetzt wird. Der Betrag dieses Versatzes hängt vom Krümmungsradius der Linse ab. Über die Wahl des Krümmungsradius läßt sich das Vergrößerungsverhältnis für die Strahltransformation einstellen. Um einen optimalen Koppelwirkungsgrad zu erhalten, wird der aus dem Halbleiterlaser austretende Strahl, der näherungsweise als Gaußstrahl betrachtet werden kann, so transformiert, daß die Taille des transformierten Laserstrahls so groß ist, wie die Strahltaille einer in der Einmodenfaser geführten Lichtwelle. Im folgenden werden Ergebnisse von Berechnungen für typische Eingangsgrößen angegeben; darin bezeichnet LD (Laserdiode) das Sendeelement 12.

Eingangsgrößen:

| Wellenlänge | $\lambda = 1{,}55\ \mu m$ |
|---|---|
| Dicke des 1. Siliziumsubstrates | $d_1 = 525\ \mu m$ |
| Dicke des 2. Siliziumsubstrates | $d_2 = 525\ \mu m$ |
| Brechungsindex des Siliziums | $n_{Si} = 3{,}4777$ |
| Dicke des Laserchips | $d_{ch} = 250\ \mu m$ |
| Dicke der Montageschicht für LD | $d_s = 25\ \mu m$ |
| Höhe der aktiven Zone über Substrat | $1\ h_a = 275\ \mu m$ |
| Modenfeldradius des Lasers | $w_L = 2{,}25\ \mu m$ |
| Modenfeldradius der Faser | $w_F = 5\ \mu m$ |
| Schnittwinkel der Faserstirnfläche horizontaler | $\delta = 8°$ |
| Abstand LD - Filterfläche 22 | $s_{121} = 225\ \mu m$ |
| Fall 1: Brechungsindex oberhalb Fläche 11 | $n_{0L} = 1$ |
| Fall 2: Brechungsindex oberhalb Fläche 11 | $n_{0K} = 1{,}5$ |

Mit diesen Eingangsgrößen ergibt die Berechnung für den Fall 1 folgende Ergebnisse für die Abbildung und den Strahlverlauf:

| Krümmungsradius der Si-Linse: | $R_K = 1100\ \mu m$ |
|---|---|
| Radius der Si-Linse | $R_L = 400\ \mu m$ |
| Taillenradius des transformierten Strahls | $w_{0Lt} = 4{,}9\ \mu m$ |
| optischer Weg Laser - Linse (Gegenstandsweite) | $g = 649\ \mu m$ |

(fortgesetzt)

| optischer Weg Linse - Faser (Bildweite) | b = 1404 μm |
|---|---|
| Vergrößerung M = b/g | M = 2,2 |
| Versatz Linsenkrümmungsmitte - Mittenstrahl | $\Delta X_K$ = 14 μm |
| Versatz Linsenmitte - Stahlmitte | $\Delta X_L$ = 120 μm |
| Strahlrichtung im Si-Substrat 1 | $\gamma_{1L}$ = 5,50° |
| Strahlrichtung unter der Si-Linse | $\gamma_4$ = 3,7° |
| erforderliche Einstrahlrichtung in Faser | $\varepsilon$ = 3,7° |

Für den Fall 2 erhält man diese Ergebnisse:

| Krümmungsradius der Si-Linse: | $R_K$ = 825 μm |
|---|---|
| Radius der Si-Linse | $R_L$ = 400 μm |
| Taillenradius des transformierten Strahls | $w_{0Lt}$ = 5,0 μm |
| optischer Weg Laser - Linse (Gegenstandsweite) | g = 482 μm |
| optischer Weg Linse - Faser (Bildweite) | b = 1072 μm |
| Vergrößerung M = b/g | M = 2,2 |
| Versatz Linsenkrümmungsmitte - Mittenstrahl | $\Delta X_{Kr}$ = 26,6 μm |
| Versatz Linsenmitte - Stahlmitte | $\Delta X_{Li}$ = 147 μm |
| Strahlrichtung im Si-Substrat 1 | $\gamma_{1K}$ = 8,27° |
| Strahlrichtung unter der Si-Linse | $\gamma_4$ = 3,7° |
| erforderliche Einstrahlrichtung in Faser | $\varepsilon$ = 3,7° |

Für die beiden Fälle mit Luft bzw. Kleber oberhalb der ersten Breitseite 11 des Substrates 1 läßt sich durch Wahl des Linsenkrümmungsradius $R_K$ von 1100 μm bzw. 825 μm und des Linsenversatzes $\Delta X_{Li}$ von 120 μm bzw. 147 μm die Taillengröße und die Strahlrichtung so anpassen, daß eine optimale Einkopplung in eine senkrecht zur Montageebene des Lasers ausgerichtete Einmodenfaser möglich ist.

Die Berechnung für die Ausbreitung der Strahlenbündel ist nach dem Reziprozitätsprinzip der Optik ebenso auch für den umgekehrten Lichtweg gültig. Das heißt, daß ein aus der Faser austretender Empfangsstrahl bis zum Auftreffen auf die dichroitische Filterschicht 22 die gleiche Transformation und Strahlumlenkung erfährt wie der Sendestrahl. Die dichroitische Filterschicht 22 hat für den Empfangsstrahl wegen dessen anderer Wellenlänge ein sehr geringes Reflexionsvermögen und ein sehr hohes Transmissionsvermögen. Der Empfangsstrahl wird hier also nicht reflektiert, sondern er tritt in das Innere des Siliziumsubstrats 2 ein. Der Einfallswinkel $\alpha_2$ des Mittenstrahls ist hier ebenso wie beim einfallenden Sendestrahl der Winkel $\beta$ = 35,3°. An der Fläche 21 wird der Empfangsstrahl zum Lot hingebrochen. Der Brechungswinkel hinter der Fläche 21 ist

$$\beta_2 = \arcsin((n_0/n_2) \cdot \sin(\alpha_2)).$$

Für den Fall 1 mit $n_0 = n_{0L}$ = 1 für Luft und $n_2 = n_{Si}$ = 3,4777 für Silizium als Substratmaterial für das Substrat 2 erhält man

$$\beta_{2L} = 9,56°.$$

Der Richtungswinkel gegenüber der Flächennormalen der Oberseite 24 des Substrates 2 ist

$$\gamma_{24L} = \alpha - \beta_{2L} = 54{,}74° - 9{,}56° = 45{,}18°$$

Für den Fall 2 mit $n_0 = n_{0K} = 1{,}5$ für Kleber und $n_2 = n_{Si} = 3{,}4777$ für Silizium als Substratmaterial für das Substrat 2 erhält man

$$\beta_{2K} = 14{,}42°.$$

Der Richtungswinkel gegenüber der Flächennormalen der Oberseite 24 des Substrates 2 ist

$$\gamma_{24L} = \alpha - \beta_{2L} = 54{,}74° - 14{,}42° = 40{,}32°$$

Der Grenzwinkel der Totalreflexion aus Silizium nach Luft ist

$$\beta_{grL} = \arcsin(1/n_{si}) = 16{,}71°.$$

Gegenüber einem transparentem Kleber mit $n_K = 1{,}5$ ist der Grenzwinkel aus Silizium

$$\beta_{grK} = \arcsin(n_K/n_{si}) = 25{,}55°.$$

Ein Austritt aus der Seite 24 des Siliziumsubstrates ist für beide Fälle nicht möglich, auch wenn die Seite 24 gegen einen transparenten Kleber grenzen würde, da der Strahlrichtungswinkel gegenüber der Flächennormalen der Seite 24 für beide Fälle größer ist als der Grenzwinkel der Totalreflexion. Eine auf der Seite 24 angebrachte Fotodiode könnte daher kein Licht aus der Übertragungsfaser 4 empfangen.

Um das Empfangslicht trotzdem aus dem Siliziumsubstrat 2 auskoppeln und in eine planar auf der Seite 24 montierte Empfangsdiode 5 einkoppeln zu können, ist entsprechend einer Weiterbildung der Erfindung eine anisotrop geätzte Vertiefung 3 in der Seite 24 des Substrates 2 erzeugt. Das Empfangslichtbündel mit dem Mittenstrahl 131 trifft auf die Seitenfläche 31 der Vertiefung 3. Da die beiden Flächen 21 und 31 wegen des gleichen anisotropen Ätzprozesses parallel zueinander sind, ist für die beiden Fälle mit Luft bzw. einem transparenten Kleber linksseitig der Fläche 21 der Einfallswinkel $\beta_{3L}$ bzw. $\beta_{3K}$ des Mittenstrahls 131 an der Begrenzungsfläche 31 so groß wie der Brechungswinkel $\beta_{2L}$ bzw. $\beta_{2K}$ rechtsseitig der Fläche 21. In beiden Fällen ist der Einfallswinkel kleiner als der Grenzwinkel der Totalreflexion, so daß das Licht aus dem Siliziumsubstrat austreten kann. Um Verluste durch Fresnelreflexionen an der Grenzfläche 31 zu vermeiden, ist diese Fläche mit einer Antireflexionsschicht 32 belegt. Anstelle einer Antireflexionsschicht kann hier auch die gleiche Filterschicht wie in Schicht 22 verwendet werden. In diesem Fall können beide Seiten des Siliziumwafers 2 im gleichen Vakuumprozeß beschichtet werden.

Die Vertiefung 3 kann entweder mit Luft oder auch mit einem transparentem Kleber gefüllt sein. Je nach Brechungsindex in der Vertiefung 3 ergeben sich für die Brechungswinkel der beiden Fälle 1 und 2 folgende Kombinationen:

Fall 1a

| Raum vor Fläche 21: | Luft | $n_{oL} = 1$ |
|---|---|---|
| Raum hinter Fläche 31: | Luft | $n_{3L} = 1$ |
| Richtungswinkel von Strahl 132 | | $\gamma_{132} = 19{,}47°$ |

Fall 1b

| Raum vor Fläche 21: | Luft | $n_{oL} = 1$ |
|---|---|---|

(fortgesetzt)

| Raum hinter Fläche 31: | Kleber | $n_{3K} = 1{,}5$ |
|---|---|---|
| Richtungswinkel von Strahl 132 | | $\gamma_{132} = 32{,}10°$ |

Fall 2a

| Raum vor Fläche 21: | Kleber | $n_{oK} = 1{,}5$ |
|---|---|---|
| Raum hinter Fläche 31: | Luft | $n_{3L} = 1$ |
| Richtungswinkel von Strahl 132 | | $\gamma_{132} = -5{,}26°$ |

Fall 2b

| Raum vor Fläche 21: | Kleber | $n_{oK} = 1{,}5$ |
|---|---|---|
| Raum hinter Fläche 31: | Kleber | $n_{3K} = 1{,}5$ |
| Richtungswinkel von Strahl 132 | | $\gamma_{132} = 19{,}47°$ |

Auf der Seite 24 des zweiten Siliziumsubstrates 2 wird die als Empfangselement dienende Empfangsdiode 5 so montiert, daß ihre lichtempfindliche Fläche über der Öffnung 33 der Vertiefung 3 liegt. Dabei kann entweder eine Fotodiode mit der aktiven Fläche auf der Oberseite, wie in Fig. 1 gezeigt, oder eine Fotodiode mit der aktiven Fläche auf der Unterseite eingesetzt werden. Die laterale Position der Fotodiode kann anhand der oben angegebenen Richtungswinkel und der Position der Vertiefung 3 bezüglich der Fläche 21 vorherbestimmt und durch Marken oder Raststrukturen auf der Seite 24 des Siliziumsubstrates 2 gekennzeichnet werden, so daß eine passive Justierung dieser Empfangsdiode möglich ist.

Die optischen Weglängen (= geometrische Weglänge geteilt durch den Brechungsindex des jeweils durchlaufenen Materials) zwischen dem Lichtaustrittspunkt $P_0$ an der Laserstirnfläche und dem Auftreffpunkt $P_{21}$ des Sendestrahls 121 auf der Fläche 21 einerseits und des Empfangslichtstrahls zwischen dem Punkt $P_{21}$ und dem Lichtauftreffpunkt $P_5$ auf der Empfangsdiode 5 andererseits lassen sich durch eine geeignete Positionierung der Vertiefung 3 bezüglich der Fläche 21 einander angleichen.Dadurch kann erreicht werden, daß im Punkt $P_5$ die Strahltaille des transformierten Empfangsstrahls zu liegen kommt, die als Abbildung der Strahltaille auf der Faserstirnfläche 42 durch die Linse 15 entsteht. Die transformierte Emfangsstrahltaille im Punkt $P_5$ hat dann den gleichen Durchmesser wie die Strahltaille des Laserstrahls an der Lichtaustrittsfläche im Punkt $P_0$ des Lasers. In dem angegebenen Beispiel sind dies 4,5 µm. Damit lassen sich auch kleinflächige Fotodioden, die für höchste Frequenzbereiche erforderlich sind (Durchmesser der aktiven Zone typisch 30 µm) noch mit ausreichendem Justagespielraum ankoppeln.

Für das erfindungsgemäße Modul ist eine kostengünstige Herstellung der Siliziumsubstrate 1 und 2 möglich, da sie im Großnutzen auf Waferebene strukturiert und beschichtet werden können. Die Montage der optoelektronischen Wandlerelemente kann ebenfalls kostengünstig auf Waferebene erfolgen. Auch die gegenseitige Ausrichtung des oberen und unteren Siliziumsubstrates kann vorteilhafterweise auf Waferebene geschehen. Dabei werden mit einem einzigen Justagevorgang alle Teilsubstrate beider Wafer gleichzeitig zueinander ausgerichtet. Diese Ausrichtung kann auch justagefrei erfolgen, wenn auf dem Wafer an mindestens zwei Stellen zueinander korrespondierende Raststrukturen gemeinsam mit der anisotropen Ätzung der übrigen Strukturen hergestellt werden. Diese Raststrukturen können beispielsweise pyramidenförmige Vertiefungen sein, in welche Präzisionskugeln eingelegt werden. Die gegenseitige Fixierung der beiden Wafer kann durch Kleben, Löten oder ein anderes bekanntes Befestigungsverfahren geschehen. Nach der Fixierung werden die Wafer vereinzelt und die einzelnen Modulbausteine auf den Leadframes montiert.

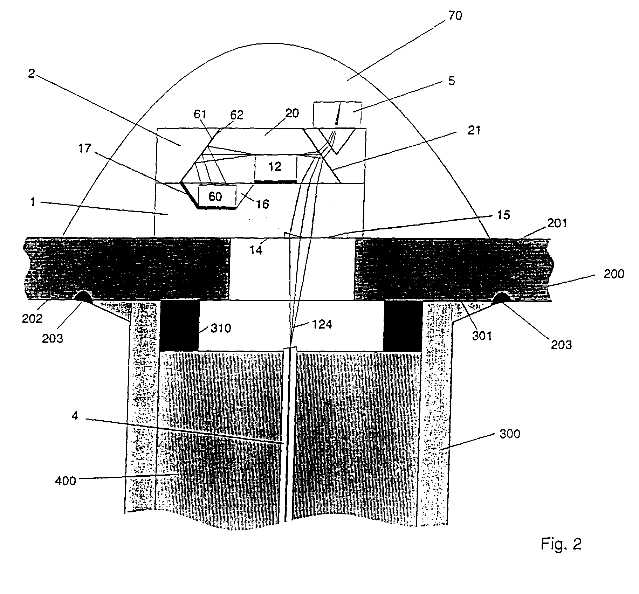

Fig. 2 zeigt ein erfindungsgemäßes Transceiver-Modul, das auf einer Seite 201 eines Leadframe 200 montiert ist. Auf der anderen Seite 202 des Leadframe 200 ist eine Steckbuchse 300 mit ihrer Flanschfläche 301 aktiv justiert und über Laserschweißpunkte 203 fixiert. In diese Steckbuchse ist eine Ferrule 400 mit der Übertragungsfaser 4 eingeführt. Diese Faser hat eine schräg geschnittene Stirnfläche (der Schnittwinkel in diesem Ausführungsbeispiel ist 8°), in die der transformierte Laserstrahl 124 eingekoppelt wird. Der axiale Abstand wird dabei durch den Anschlagring 310 so voreingestellt, daß zwischen der Linse 15 auf der Unterseite 14 des Siliziumsubstrates 1 und der Taille des transformierten Laserstrahls 124 gerade die oben berechnete Bildweite b liegt. Die laterale Position der Faser bezüglich der Strahltaille des transformierten Laserstrahls wird durch aktive Justage der Flanschfläche 301 auf der Unterseite 202 des Leadframes 200 eingestellt und durch Laserschweißpunkte 203 fixiert.

Das aus der Rückseite des Laserchips austretende Lichtsignal kann, wie nach dem Stand der Technik üblich, zur Leistungsregelung verwendet werden. Der erfindungsgemäße Aufbau bietet hierzu eine vorteilhafte Lösung zur Strahlumlenkung auf eine planar montierte Monitordiode 60. Diese Monitordiode wird erfindungsgemäß in einer Vertiefung 16 im Siliziumsubstrat 1 montiert. Das obere Siliziumsubstrat 2 erhält eine weitere anisotrop geätzte Fläche 61, die der Fläche 21 gegenüberliegt. Beide Flächen 21 und 61 sind dabei die Seitenflächen einer anisotrop geätzten Öffnung 20 im oberen Siliziumsubstrat 2. Die Strahlumlenkung des rückwärtig austretenden Laserstrahls geschieht durch Reflexion an der Fläche 61, die hierzu mit einer die Laserwellenlänge reflektierenden Schicht 62 belegt ist. Vorteilhafterweise kann diese Schicht 62 den gleichen Aufbau haben, wie die dichroitische Schicht 22 auf der Fläche 21 und mit dieser gemeinsam ohne wesentlichen Mehraufwand hergestellt werden. Zur elektrischen und mechanischen Kontaktierung der Unterseite der Monitordiode 60 wird der Boden und mindestens eine der Seitenflächen der Vertiefung 16 mit einer Goldschicht 17 belegt. Die übrige elektrische Kontaktierung des Empfangs- und Sendezweigs des Transceiver-Moduls geschieht über Bonddrähte zu den entsprechenden Kontaktbereichen des Leadframes (hier nicht gezeichnet). Zum Schutz vor Umwelteinflüssen können die aktiven Bauelemente des Transceivers und die Bonddrähte mit einem optisch transparenten Schutzverguß (engl. glob top) 70 umhüllt sein. Das Gesamtmodul kann dann noch mit einer harten Umhüllung (hier nicht gezeichnet) umgeben werden.

Abwandlungsmöglichkeiten:

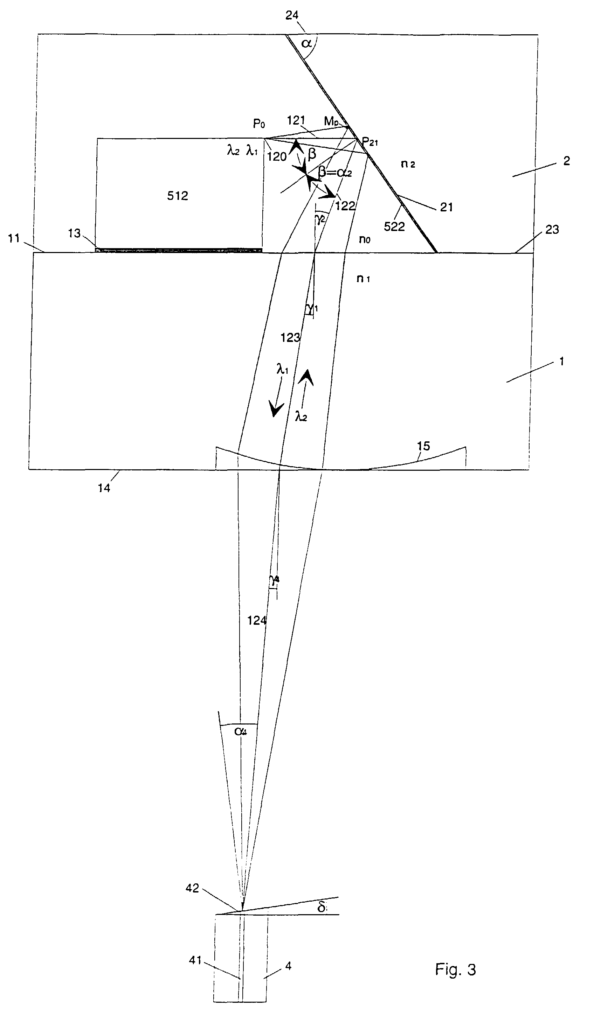

Anstelle des Laserchips 12 kann auch ein integrierter Transceiverchip 512 (Fig. 3) eingesetzt werden. Ein solcher Transceiverchip enthält auf einem Chip integriert einen Sendeteil, der die Wellenlänge $\lambda_1$ aussendet und einen Empfangsteil, der die Empfangswellenlänge $\lambda_2$ empfängt. Das Sende- und das Empfangslicht werden über denselben Ein- und Ausgangswellenleiter auf dem Chip geführt und haben denselben Lichtein- und -austrittsfleck, der an der Stelle $P_0$ liegt. Dieser gemeinsame Ein- und Ausgangswellenleiter kann, wie zuvor beschrieben, als Transformationswellenleiter zur Vergrößerung des Modenfelddurchmessers ausgebildet sein. Die Strahlengänge für die Sende- und die Empfangsrichtung sind dann so, wie zuvor für die Senderichtung beschrieben wurde. Die dichroitische Filterschicht 22 wird nun durch eine Reflexionsschicht 522 für beide Wellenlängen ersetzt. Die Trennung der Wellenlängen geschieht auf dem integrierten Transceiverchip durch einen dort integrierten wellenlängenselektiven Koppler. Zusätzlich kann der Transceiverchip auch eine integrierte Monitordiode enthalten, so daß die Monitordiode 60 nach Figur 2 in der Vertiefung 16 mit der zur Strahlumlenkung vorgesehenen Fläche 61 entfallen kann.

Ebenso ist es möglich, die erfindungsgemäße Anordnung ganz ohne Empfangsteil, also ohne die Fotodiode 5 und ohne die Vertiefung 3 nur mit dem Laserchip 12 als reines Sendemodul zu verwenden.

**Patentansprüche**

1. Elektrooptisches Modul

   - mit einem optisch durchlässigen, plattenförmigen Substrat (1) mit zwei planparallelen Breitseiten (11, 14),
   - mit einem optischen Sendeelement (12, 512), das zur Erzeugung von Sendestrahlung dient und das in einem ersten Vorraum vorgesehen ist, der der ersten Breitseite (11) vorgelagert ist,
   - mit Mitteln zur Strahlformung für die Einkopplung in eine Einkopplungsfläche, die sich im Vorraum der zweiten Breitseite (14) befindet, wobei die zweite Breitseite (14) einen strukturierten Oberflächenbereich aufweist, der als Mittel zur Fokussierung der im Betrieb durch das Substrat (1) geworfenen Sendestrahlung auf die Einkopplungsfläche dient,
   - mit folgenden Merkmalen:

     - die erste Breitseite (11) weist eine kristallographische (100)-Orientierung auf,
     - im ersten Vorraum ist eine die Sendestrahlung im Betrieb reflektierende und auf die erste Breitseite (11) werfende Fläche (21) angeordnet,
     - die ebene Fläche (21) hat eine kristallographische (111)-Orientierung gegenüber der kristallographischen (100)-Orientierung der ersten Breitseite (11),

- im Vorraum der zweiten Breitseite (14) ist der Einkopplungsfläche eine Aufnahmevorrichtung (300, 310) für einen Halter (400) eines optischen Wellenleiters (4) mit Stirnfläche (42) zugeordnet,
- der strukturierte Oberflächenbereich ist so lokalisiert, daß im Betrieb die Richtung des Mittenstrahls (123, 124) der Sendestrahlung im Vorraum der zweiten Breitseite (14) weniger von dem Lot auf der zweiten Breitseite (14) abweicht als innerhalb des Substrats (1).

2. Modul nach Anspruch 1, dadurch gekennzeichnet, daß die Emissionsrichtung des Sendeelements (12, 512) parallel zur ersten Breitseite (11) verläuft.

3. Modul nach Anspruch 1 oder 2, dadurch gekennzeichnet, daß der strukturierte Oberflächenbereich als konvexe Linse (15) gestaltet ist.

4. Modul nach Anspruch 3, dadurch gekennzeichnet, daß, der Krümmungsradius der Linse (15) so gewählt ist, daß der aus dem Sendeelement (12, 512) austretende Sendestrahl so transformiert wird, daß die Taille des transformierten Sendestrahls so groß ist wie die Strahltaille einer in einer handelsüblichen Einmodenfaser geführten Lichtwelle.

5. Modul nach einem der vorangehenden Ansprüche, dadurch gekennzeichnet, daß die Fläche (21) durch anisotropes Ätzen eines plattenförmigen Siliziumsubstrates (2) geformt ist, das so auf der ersten Breitseite (11) montiert ist, daß die (100)-Orientierung des Siliziumsubstrates (2) parallel zur ersten Breitseite (11) verläuft.

6. Modul nach einem der vorangehenden Ansprüche, dadurch gekennzeichnet, daß es zusätzlich zum Sendeelement (12) ein Empfangselement (5) aufweist.

7. Modul nach einem der vorangehenden Ansprüche, dadurch gekennzeichnet, daß die Fläche (21) reflektierend für die Sendestrahlung, aber durchlässig für Strahlung mindestens einer anderen als Empfangswellenlänge geeigneten Wellenlänge ist.

8. Modul nach einem der vorangehenden Ansprüche, dadurch gekennzeichnet, daß parallel zur Fläche (21) eine Begrenzungsfläche (31) liegt, die zusammen mit der Fläche (21) einen Plattenabschnitt begrenzt, der aus einem Material besteht, das optisch durchlässig ist für eine von der Sendewellenlänge des Sendeelementes (12) abweichende Wellenlänge und das einen höheren Brechungsindex aufweist als die Vorräume der Fläche (21) und der Begrenzungsfläche (31).

9. Modul nach Anspruch 8, dadurch gekennzeichnet, daß die Begrenzungsfläche (31) auch eine anisotrop in eine Siliziumplatte (2) geätzte Vertiefung (3) begrenzt.

10. Modul nach Anspruch 6 und 9, dadurch gekennzeichnet, daß die Siliziumplatte (2) auf einer ihrer Breitseiten (24) das Empfangselement (5) trägt.

11. Modul nach einem der Ansprüche 6 bis 10, dadurch gekennzeichnet, daß die optischen Weglängen zwischen einerseits der Fläche (21) und andererseits dem Lichtaustrittspunkt (P0) an dem Sendeelement beziehungsweise dem Auftreffpunkt (P5) des Empfangslichtstrahls auf dem Empfangselement (5) einander angeglichen sind.

12. Modul nach einem der Ansprüche 6 bis 11, dadurch gekennzeichnet, daß Brechzahlen und Geometrie so gewählt sind, daß im Betrieb im Auftreffpunkt (P5) des Empfangslichtstrahls auf dem Empfangselement (5) die Strahltaille des transformierten Empfangsstrahls liegt, die durch die Linse (15) als Abbildung der Strahltaille in der Einkopplungsfläche entsteht.

13. Modul nach einem der Ansprüche 1 bis 6, dadurch gekennzeichnet, daß das Sendeelement Bestandteil eines Transceiverchips (512) mit integriertem Empfangselement ist und daß die Fläche (21) sowohl für die Sende- als auch für die Empfangswellenlänge reflektierend ist.

Fig. 1

Fig. 2

Fig. 3